Europäisches Patentamt

(19) European Patent Office

Office européen des brevets

(11) Publication number: **0 144 998**
A2

(12) **EUROPEAN PATENT APPLICATION**

(21) Application number: **84114990.9**

(22) Date of filing: **08.12.84**

(51) Int. Cl.⁴: **B 23 K 35/14**
**B 23 K 35/26, B 23 K 35/30**

(30) Priority: **13.12.83 US 561100**
**19.06.84 US 622313**
**21.11.84 US 672682**

(43) Date of publication of application:
**19.06.85 Bulletin 85/25**

(84) Designated Contracting States:
**DE FR GB IT**

(71) Applicant: **ALLIED CORPORATION**
**Columbia Road and Park Avenue P.O. Box 2245R (Law Dept.)**
**Morristown New Jersey 07960(US)**

(72) Inventor: **Bedell, John Robert c/o Allied Corporation**
**P.O. Box 2245R**
**Morristown, NJ 07960(US)**

(72) Inventor: **Hemmat, Naim c/o Allied Corporation**
**P.O. Box 2245R**
**Morristown, NJ 07960(US)**

(72) Inventor: **Rabinkin, Anatol c/o Allied Corporation**
**P.O. Box 2245R**
**Morristown, NJ 07960(US)**

(72) Inventor: **Bose, Debasis c/o Allied Corporation**
**P.O. Box 2245R**
**Morristown, NJ 07960(US)**

(72) Inventor: **Datta, Amitava c/o Allied Corporation**
**P.O. Box 2245R**
**Morristown, NJ 07960(US)**

(72) Inventor: **DeCristofaro, Nicholas John c/o Allied Corporation**
**P.O. Box 2245R**
**Morristown, NJ 07960(US)**

(74) Representative: **Weber, Dieter, Dr. et al,**
**Dr. Dieter Weber und Klaus Seiffert Patentanwälte**
**Gustav-Freytag-Strasse 25 Postfach 6145**
**D-6200 Wiesbaden 1(DE)**

(54) **Rapid solidified soldering filler metals.**

(57) A rapidly solidified, homogeneous soldering foil has a thickness ranging from 12 to 200 micrometers. The foil is at least 2 millimeters wide, of substantially uniform cross section along its length and has a composition consisting essentially of at least two elements selected from the group consisting of Au, Ag, Pb, Bi, Si, Sn, Sb, In and Ge.

FIGURE 2

Croydon Printing Company Ltd.

## BACKGROUND OF THE INVENTION
### RAPIDLY SOLIDIFIED SOLDERING FILLER METALS
### CROSS REFERENCE TO RELATED APPLICATIONS

This is a continuation-in-part of copending application Serial No. 622,313, filed June 19, 1984 which, in turn, is a continuation-in-part of application Serial No. 561,100, filed December 13, 1983 for Rapid Solidified Soldering Filler Metals.

### 1. Field of the Invention

This invention relates to soldering of electronic components, and in particular, to a homogeneous, ductile soldering material useful in soldering semiconductor devices to metal or ceramic parts.

### 2. Description of the Prior Art

Soldering is a process for metallurgical bonding of material often of dissimilar compositions to each other. Typically, a filler metal that has a melting point lower than that of the base material parts to be joined together is interposed between the metal parts to form an assembly. The assembly is then heated to a temperature sufficient to melt the filler metal. Upon cooling, a sound leak tight joint is formed.

The process of soldering is usually employed for joining a transistor or other semi-conductor device (called die or chip) to a metal or ceramic part (called lead frame) to provide support to the device. This operation is commonly referred to as die attachment. When the device is in use it generates heat, which is transferred to the lead frame through the soldered joint. The joint, therefore, has to be sound and void-free to dissipate heat efficiently. In addition, very frequently the devices are repeatedly turned on and off, thereby creating thermal stresses in the soldered joint. Ideally, the joint should be chemically homogeneous to withstand such stresses. Segregation of intermetallic compounds in the joint oftentimes leads to failure when thermal cycling is subsequently imposed, resulting in permanent damage to the device.

-2-

Commonly used soldering alloys for such applications consist of two or more of the following elements: Au, Si, Sn, Pb, Sb, In, Ag, Bi, Ge. Usually the soldering alloys are fabricated into thin foil form by conventional metalworking processes, such as rolling, in which a billet or ingot is rolled and annealed repeatedly until the desired thickness of the foil is obtained. Intermetallic compounds, segregated within the billet or ingot, are thus transferred to the final product. Furthermore, such conventional metalworking processes are slow and their yield is less than 100%.

In addition, grease or oil commonly used as lubricants during rolling operations get entrapped in the foil. During soldering, outgassing of the entrapped grease or oil generates voids in the joint, resulting in poor heat transfer from the transistor to the lead frame and reduced joint strength.

Solidification of solder-wire is disclosed in U.S. Patent 112,054 to Lang. No disclosure is contained therein that the solder product is rapidly solidified, homogeneous or in foil form.

Rapid solidification of narrow metallic filaments is disclosed in U.S. Patent 2,825,108 to Pond. No disclosure is contained therein of the use of such filaments in soldering applications.

Direct casting of liquid metal alloys to a strip form has been disclosed in U.S. Patent 4,331,739 issued on May 25, 1982. In this process, continuous metal strips are formed by forcing molten metal onto the surface of a moving chill body under pressure through a slotted nozzle located in close proximity to the surface of the chill body. Critical selection of nozzle dimensions, velocity of movement of the chill body surface, and gap between nozzle and chill body surface permits production of continuous polycrystalline metal strip at high speeds, and of amorphous metal strips having high isotropic strengths, heretofore unobtainable dimensions and other isotropic physical properties such as magnet- izability.

Application of this technique to process soldering alloys into thin strip form which exhibits uniform chemical homogeneity was not disclosed therein, however.

There remains a need in the art for a soldering alloy in foil form, which is free of organic contaminants and which is chemically homogeneous.

## SUMMARY OF THE INVENTION

The present invention provides an metal article that has been soldered with a rapidly solidified, homogeneous soldering filler metal foil. Generally stated, the article maybe comprised of metallic, ceramic and/or semiconductor parts, and the soldering foil is an alloy that consists essentially of at least two elements selected from the group consisting of Au, Si, Sn, Pb, Sb, In, Ag, Bi and Ge. Foils produced by rapidly solidifying a melt of such an alloy on a moving chill surface may exhibit amorphous, partially amorphous or polycrystalline structure depending primarily on the alloy composition. However, irrespective of the atomic structure, foils produced by this technique always exhibit chemical homogeneity. Furthermore, no grease or oil is used in this process. Therefore, generation of voids in the soldered joint resulting from outgassing of organic contaminants is eliminated. Moreover, the rapid solidification process as disclosed in U.S. Patent 4,221,257 (which disclosure is incorporated herein by reference thereto) converts liquid metal to a solid strip form in one step, making this process much more economical as compared to conventional methods of producing metal strips usually consisting of multiple steps.

In addition, the invention provides a process for joining together two or more parts comprising the steps of:

(a) interposing a filler metal foil between the parts to be joined to form an assembly, the filler metal foil having a melting temperature less than that of any of the parts to be joined;

(b) heating the assembly to at least the melting temperature of the filler metal, and cooling the assembly, wherein the improvement comprises employing as the filler metal at least one homogeneous soldering foil produced by melting an alloy, the composition of which consists essentially of at least two elements selected from the group consisting of Au, Ag, Pb, Si, Sn, Sb, In, and Ge; and quenching the alloy on a rapidly moving chill surface at a rate of at least about $10^3$°C/sec.

Alternatively, the joining operation can be performed by a process comprising the steps of:

(a) placing a filler metal on one of the parts to be joined to form as assembly, the filler metal having a melting temperature less than that of any of the parts to be joined;

(b) heating the assembly to at least the melting temperature of the filler metal;

(c) placing a second of the parts to be joined on the molten filler metal; and

(d) cooling the assembly, the filler metal being at least one homogeneous soldering foil produced by the process described in the preceding paragraph.

BRIEF DESCRIPTION OF THE DRAWINGS

The invention will be more fully understood and further advantages will become apparent when reference is made to the following detailed description of the preferred embodiment of the invention and the accompanying photomicrographs, in which:

FIG. 1 shows a EPMA (Electron Probe Micro Analysis) x-ray map of a rolled $Sn_{65}Ag_{25}Sb_{10}$ (w/o) foil illustrating chemical inhomogeneity as evidenced by typical segregation of Ag;

FIG. 2 is a EPMA map of a rapidly solidified alloy having the composition $Sn_{65}Ag_{25}Sb_{10}$, the Figure illustrating uniform chemical homogeneity as evidenced by absences of segregation;

FIG. 3 is an EPMA map of a rapidly solidified foil

-5-

having the composition $Sn_{95}Ag_5$;

FIG. 4 is an EPMA map of a rapidly solidified foil having the composition $Sn_5Pb_{95}$;

FIG. 5 is an EPMA map of a rapidly solidified foil having the composition $Ag_{2.5}Pb_{95}In_5$;

FIG. 6 is an EPMA map of a rapidly solidified foil having the composition $Sn_{95}Bi_5$;

FIG. 7 is an EPMA map of a rapidly solidified foil having the composition $Au_{98}Si_2$;

FIG. 8 is an EPMA map of a rapidly solidified foil having the composition $Sn_{63}Pb_{37}$;

FIG. 9 is an EPMA map of a rapidly solidified foil having the composition $Sn_{60}Pb_{40}$;

FIG. 10 is an EPMA map of a rapidly solidified foil having the composition $Pb_{60}Sn_{40}$;

FIG. 11 is an EPMA map of a rapidly solidified foil having the composition $Pb_{85}Sn_{15}$;

FIG. 12 is an EPMA map of a rapidly solidified foil having the composition $In_{97}Ag_3$;

FIG. 13 is an EPMA map of a rapidly solidified foil having the composition $Pb_{97.5}Ag_{1.5}Sn_1$;

FIG. 14 is an EPMA map of a rapidly solidified foil having the composition $Pb_{92.5}Sn_5Ag_{2.5}$;

FIG. 15 is an EPMA map of one surface of the filler metal of a soldered joint, the joint having been soldered with a rapidly solidified, homogeneous soldering filler metal foil having the composition $Pb_{95}Sn_5$; and

FIG. 16 is an EPMA map of one surface of the filler metal of a soldered joint, the joint having been soldered with a rolled foil having the composition $Pb_{95}Sn_5$.

## DETAILED DESCRIPTION OF THE INVENTION

In any soldering process, particularly when used for die attachments, the soldering foil should preferably be chemically homogeneous and should be free of any organic contaminants. The term "chemically homogeneous", as used herein with respect to the soldering foil of the invention, means that all individual phases within the foil having a composition different from the matrix are smaller than about .5 micrometer. More generally stated, the term "chemically homogeneous" means that the foil, as produced, is of substantially uniform composition in all directions. A chemically homogeneous soldered joint is achievable when the foil used for soldering is chemically homogeneous. Soldered joints should also be sound, i.e., should be free of voids and pores. A sound, chemically homogeneous soldered joint exhibits superior mechanical properties compared to one which contains voids and which is chemically inhomogeneous. Generally, the soldering foils are produced by conventional metalworking tecnniques, in which a billet or ingot is repeatedly rolled and annealed until the desired thickness of the foil is obtained. Intermetallic phases, segregated within the billet or ingot, are thus transferred to the final product. In addition, grease or oil commonly used as lubricants during metalworking gets entrapped in the foil. Therefore, foils produced by conventional metalworking techniques are usually chemically inhomogeneous and contain organic contaminants.

In accordance with the invention there is provided an article soldered with a homogeneous soldering material in foil form. Generally stated, the soldering material is made from alloys consisting essentially of at least two of the elements, Au, Si, Sn, Pb, Sb, In, Ag, Bi and Ge. The soldering foil of the invention is prepared by cooling a melt of the desired composition at a rate of at least $10^3$°C/sec, employing metal alloy rapid quenching techniques as discussed in U.S. Patent 4,331,739. The purity of all compositions is that found in normal commercial practice.

A variety of techniques are available for fabricating continuous ribbon, wire, sheet, etc. Typically, a particular composition is selected, powders or granules of the requisite elements in the desired portions

-7-

are melted and homogenized, and the molten alloy is rapidly quenched on a chill surface, such as rapidly rotating metal cylinder. Under these quenching conditions, foils so produced may exhibit amorphous, partially amorphous or polycrystalline structures, depending primarily on the alloy compositions. However, irrespective of the atomic structure, foils produced by this technique are always chemically homogeneous. Furthermore, no grease or oil is used in this process during casting, therefore foils so produced are free of organic contaminants. The soldering material of the invention is advantageously produced in foil (or ribbon) form and may be used in soldering applications, as cast.

Articles soldered with the rapidly solidified, homogeneous soldering foil of the present invention have an advantageous combination of mechanical and thermal properties. Such articles consist of metallic ceramic and/or semiconductor parts. These properties include high joint strength and thermal fatigue resistance, low joint porosity (that is a low fraction of voids at the soldered interface) and high joint thermal conductivity. Such properties reduce the rejection rate and increase the service life of soldered articles. This combination of improved mechanical and thermal properties increases the reliability of the soldered articles, with the result that such articles are especially suited for use in packaging microelectronic components, such as integrated circuits, hermetic seals, and the like.

Foils produced by the processing described above typically are about 13 um (0.0005") to 76 um (0.003") thick.

### EXAMPLE 1

Ribbons of about 3.175 mm (0.125") wide and about 13 to 76 )m (about 0.0005 to 0.003 inch) thick were formed by squirting a melt of the particular composition by overpressure of argon onto a rapidly rotating chill wheel (surface speed about 1200 to 6000 ft/min). Homogeneous ribbons having compositions set forth in Table I were produced.

For comparative purposes, commercially available rolled foil of dimensions of about 3.175 mm (0.125") wide by about 0.05 mm (0.002") thick and of nominal chemical composition identical to that of Sample No. 1 in Table I was obtained.

TABLE I

Composition (wt%)

| Sample No. | Sn | Ag | Sb | Pb | Bi | Au | Si | In |
|---|---|---|---|---|---|---|---|---|
| 1 | 65 | 25 | 10 | - | - | - | - | - |
| 2 | 95 | 5 | - | - | - | - | - | - |
| 3 | 5 | - | - | 95 | - | - | - | - |
| 4 | - | 2.5 | - | 92.5 | - | - | - | 5 |
| 5 | 95 | - | - | - | 5 | - | - | - |
| 6 | - | - | - | - | - | 98 | 2 | - |
| 7 | 63 | - | - | 37 | - | - | - | - |
| 8 | 60 | - | - | 40 | - | - | - | - |
| 9 | 40 | - | - | 60 | - | - | - | - |
| 10 | 15 | - | - | 85 | - | - | - | - |
| 11 | - | 3 | - | - | - | - | - | 97 |
| 12 | 1 | 1.5 | - | 97.5 | - | - | - | - |
| 13 | 5 | 2.5 | - | 92.5 | - | - | - | - |

EXAMPLE 2

The distribution of various elements in the foil samples was determined by x-ray area scanning. In this technique, the applied signal from the detector system - energy dispersive (EDS) or wavelength dispersive (WDS) - is made to modulate the brightness of a cathode ray tube (CRT) scanned in synchronism with the electron probe. A picture is obtained by the variation of x-ray emission from the specimen surface. Such x-ray area scans, commonly called elemental maps show tones ranging from black to white. In places of high concentration of the element in the scanned area, the picture is nearly photographically white; it is grey where the element's concentration is lower and black where the element is absent.

### EXAMPLE 3

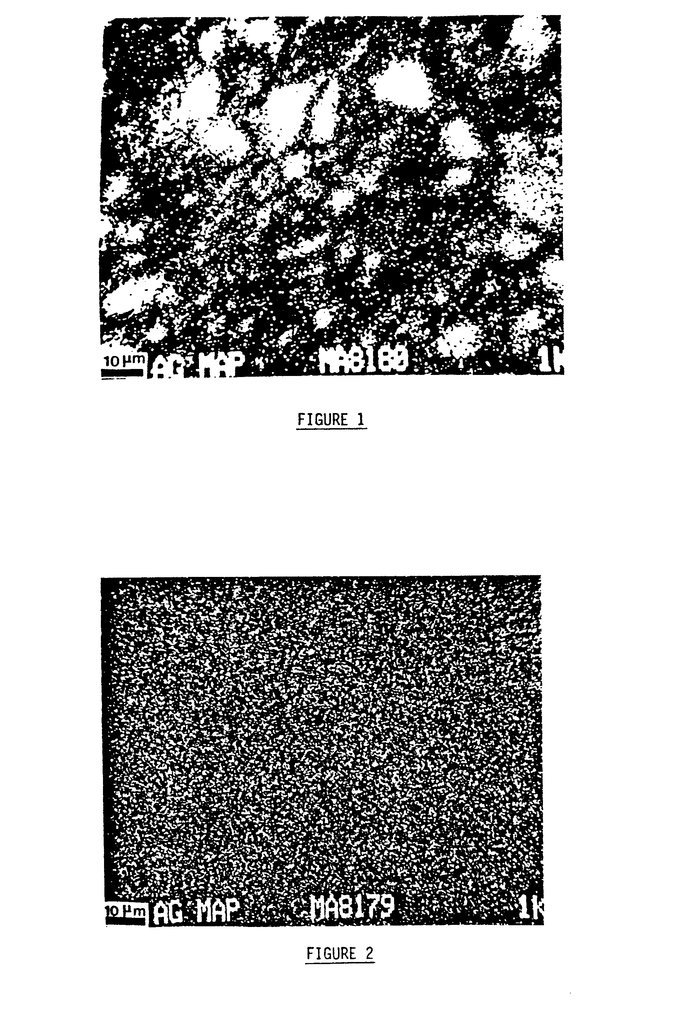

Figure 1 illustrates the Ag map of a rolled foil sample of composition as in Sample No. 1 in Table I. The figure, which shows extensive segregation of Ag (shown by arrows), indicating chemical inhomogeneity in the structure is a typical representation of foils produced by conventional metalworking processes.

On the contrary, the Ag map of the foil produced by rapid quenching of molten alloy having composition of Sample No. 1 in Table I on a rotating chilled wheel exhibits a uniform distribution of Ag (white images), indicating chemical homogeneity.

It can be concluded, therefore, that rapid solidification of a molten alloy on a rotating chilled wheel produces foil having uniform chemical homogeneity, whereas, the same alloy when fabricated by conventional metalworking processes to a foil form usually exhibits chemical inhomogeneity.

### EXAMPLE 4

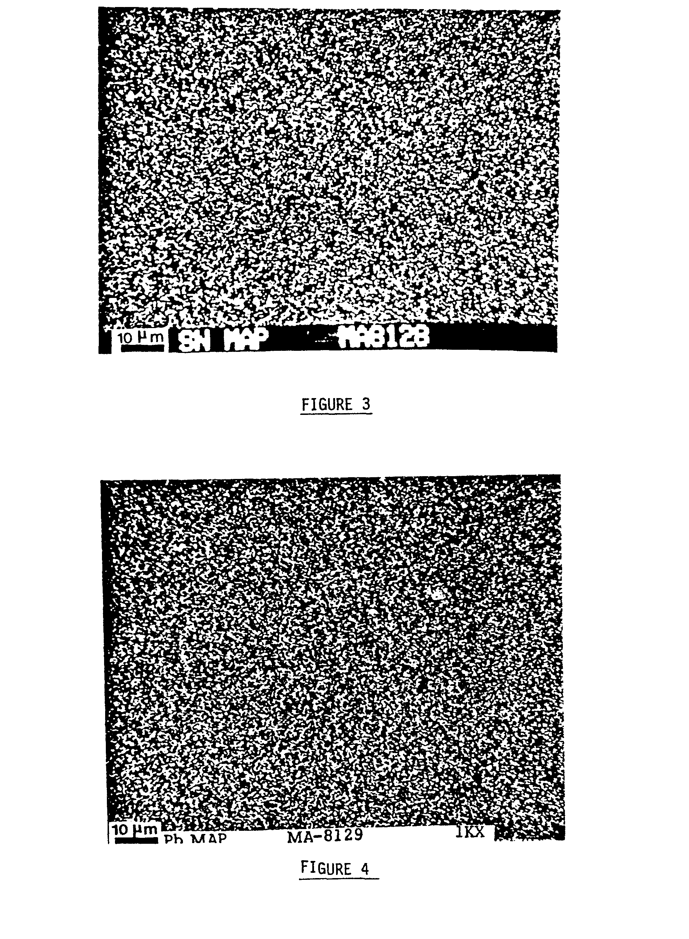

Figure 3 illustrates the Sn map of a rapidly solidified foil sample of composition of Sample No. 2 as in Table I. The photomicrograph demonstrates uniform distribution of Sn (white images) confirming uniform chemical homogeneity of the foil sample.

### EXAMPLE 5

Figure 4 illustrates the Pb map of rapidly solidified foil sample of composition of Sample No. 3 as in Table I. The photomicrograph demonstrates uniform distribution of Pb (white images) which confirms uniform chemical homogeneity of the foil sample.

### EXAMPLE 6

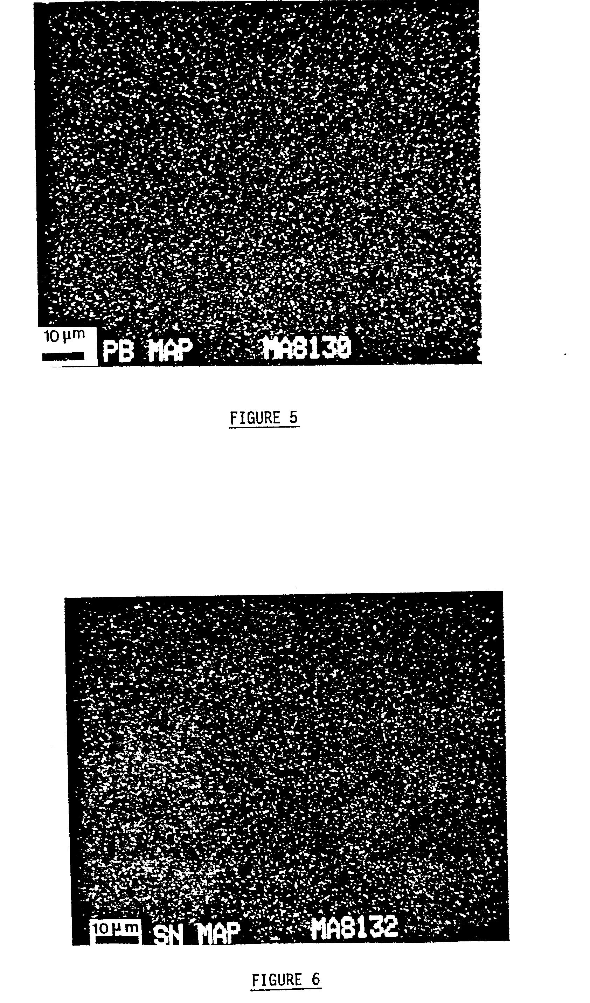

Figure 5 illustrates the Pb map of a rapidly solidified foil sample of composition of Sample No. 4 as in Table I. The photomicrograph demonstrates uniform distribution of Pb (white images) confirming uniform chemical homogeneity of the foil sample.

### EXAMPLE 7

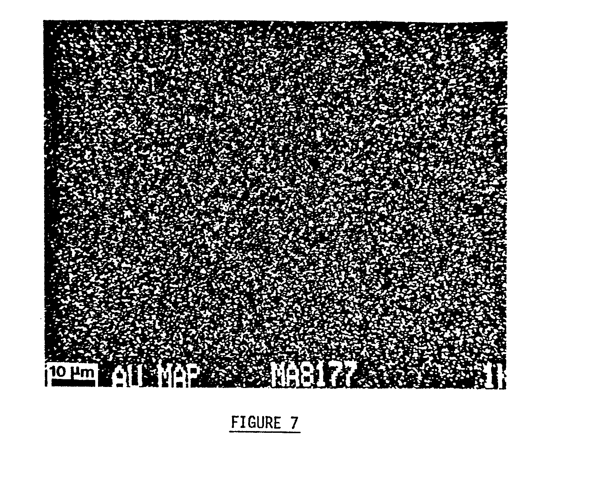

Figure 6 illustrated the Sn map of a rapidly soli-

-10-

dified foil sample of composition of Sample No. 5 as in Table I. The photomicrograph demonstrates uniform distribution of Sn (white images) confirming uniform chemical homogeneity of the foil sample.

## EXAMPLE 8

Figure 7 illustrates the Au map of a rapidly solidified foil sample of composition of Sample No. 6 as in Table I. The photomicrograph demonstrates uniform distribution of Au (white images) confirming chemical homogeneity of the foil sample.

## EXAMPLE 9

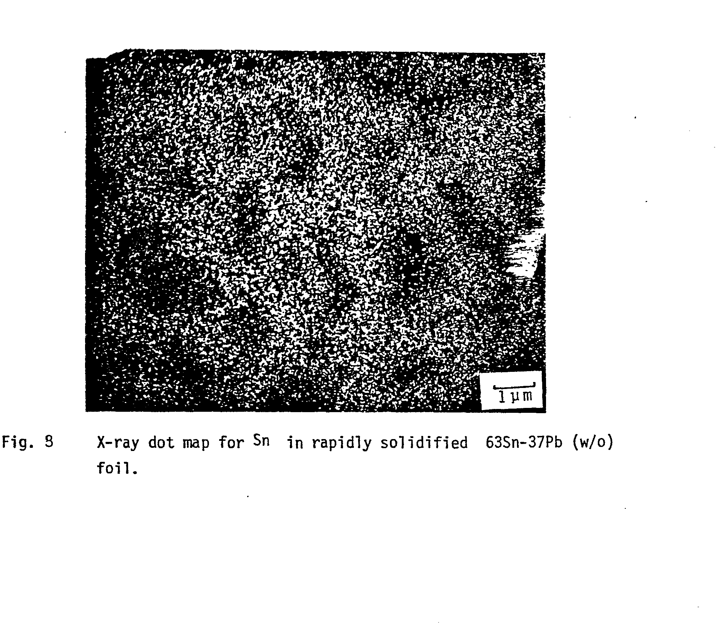

Figure 8 illustrates the Sn map of a rapidly solidified foil sample of composition of Sample No. 7 as in Table I. The photomicrograph demonstrates uniform distribution of Sn (white images) confirming uniform chemical homogeneity of the foil sample.

## EXAMPLE 10

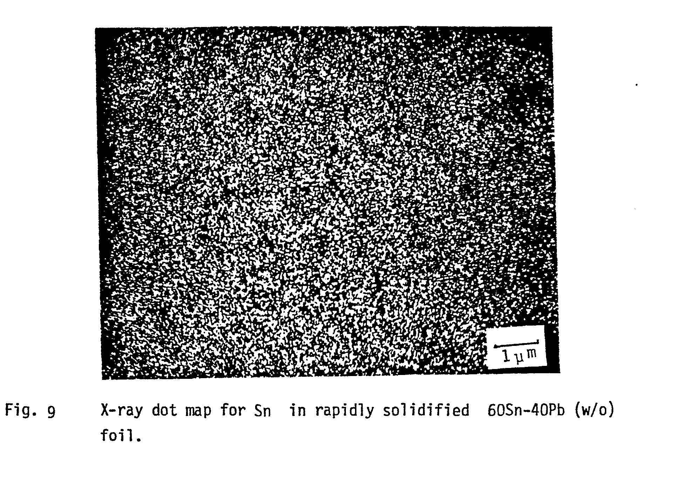

Figure 9 illustrates the Sn map of rapidly solidified foil sample of composition of Sample No. 8 as in Table I. The photomicrograph demonstrates uniform distribution of Sn (white images) which confirms uniform chemical homogeneity of the foil sample.

## EXAMPLE 11

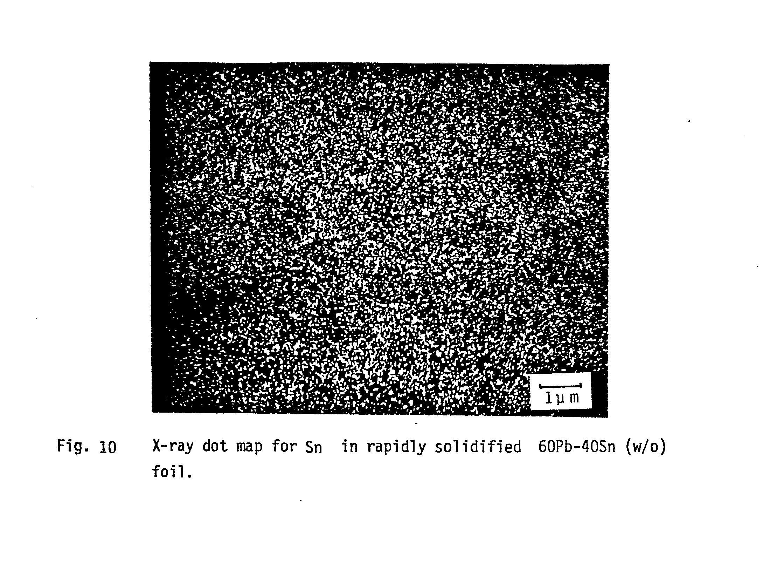

Figure 10 illustrates the Sn map of a rapidly solidified foil sample of composition of Sample No. 9 as in Table I. The photomicrograph demonstrates uniform distribution of Sn (white images) confirming uniform chemical homogeneity of the foil sample.

## EXAMPLE 12

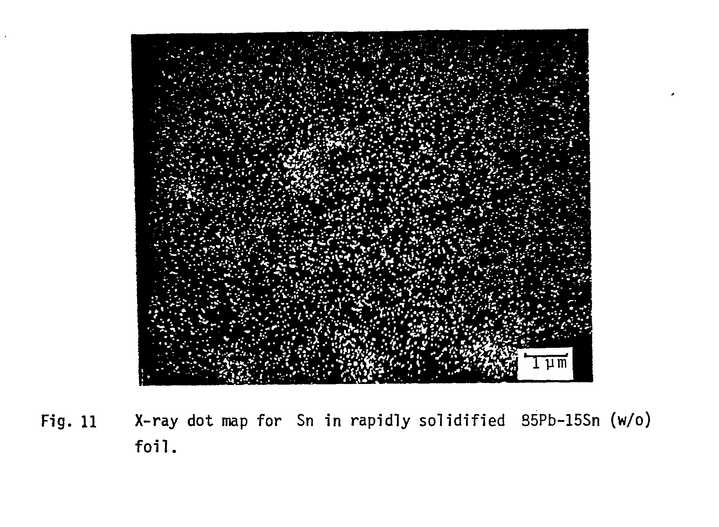

Figure 11 illustrates the Sn map of rapidly solidified foil sample of composition of Sample No. 10 as in Table I. The photomicrograph demonstrates uniform distribution of Sn (white images) which confirms uniform chemical homogeneity of the foil sample.

## EXAMPLE 13

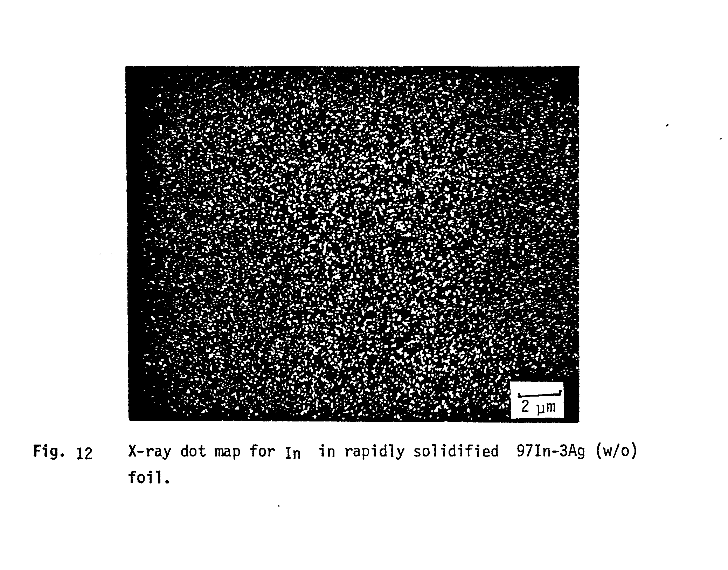

Figure 12 illustrates the In map of a rapidly solidified foil sample of composition of Sample No. 11 as in Table I. The photomicrograph demonstrates uniform distribution of In (white images) confirming uniform chemical homogeneity of the foil sample.

## EXAMPLE 14

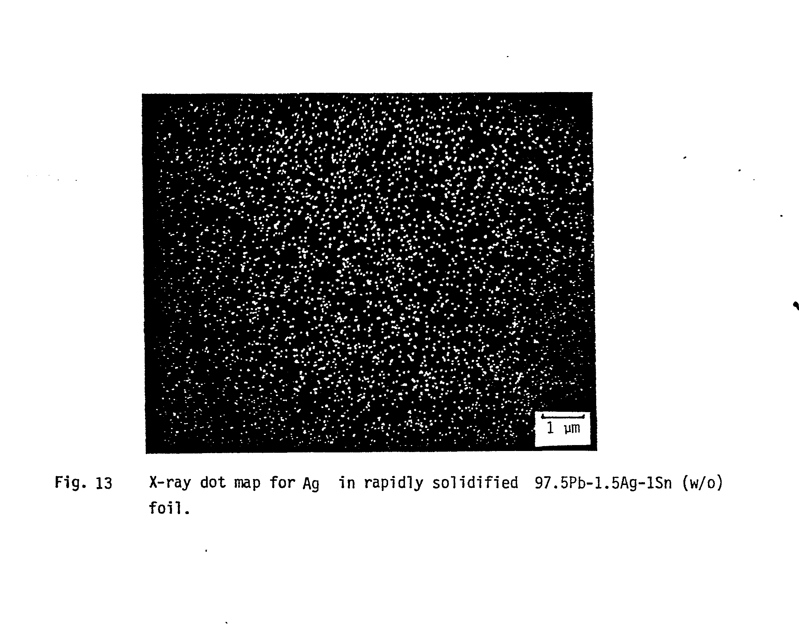

Figure 13 illustrates the Ag map of rapidly solidified foil sample of composition of Sample No. 12 as in Table I. The photomicrograph demonstrates uniform distribution of Ag (white images) which confirms uniform chemical homogeneity of the foil sample.

## EXAMPLE 15

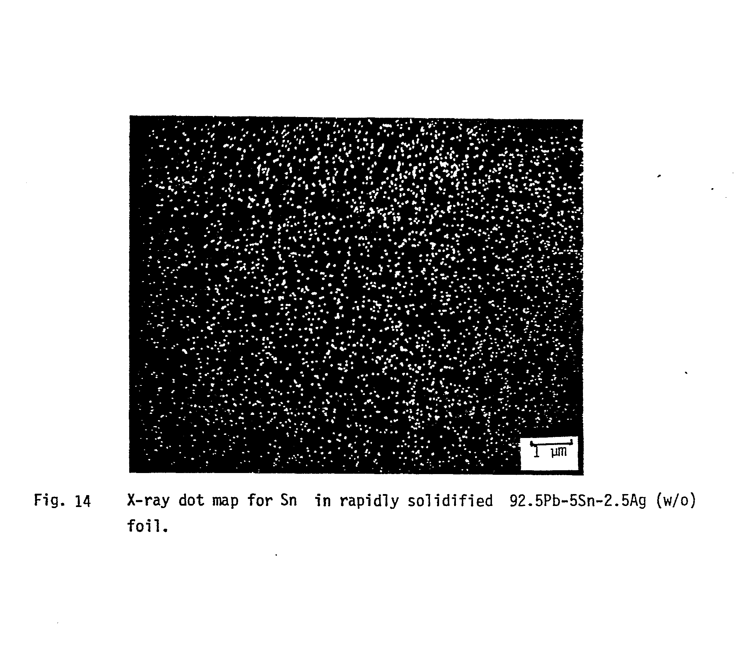

Figure 14 illustrates the Sn map of a rapidly solidified foil sample of composition of Sample No. 13 as in Table I. The photomicrograph demonstrates uniform . distribution of Sn (white images) confirming uniform chemical homogeneity of the foil sample.

## EXAMPLE 16

In order to demonstrate that joints produced by homogeneous rapidly solidified soldering foils are also homogeneous, soldered joints were made and examined in the following manner.

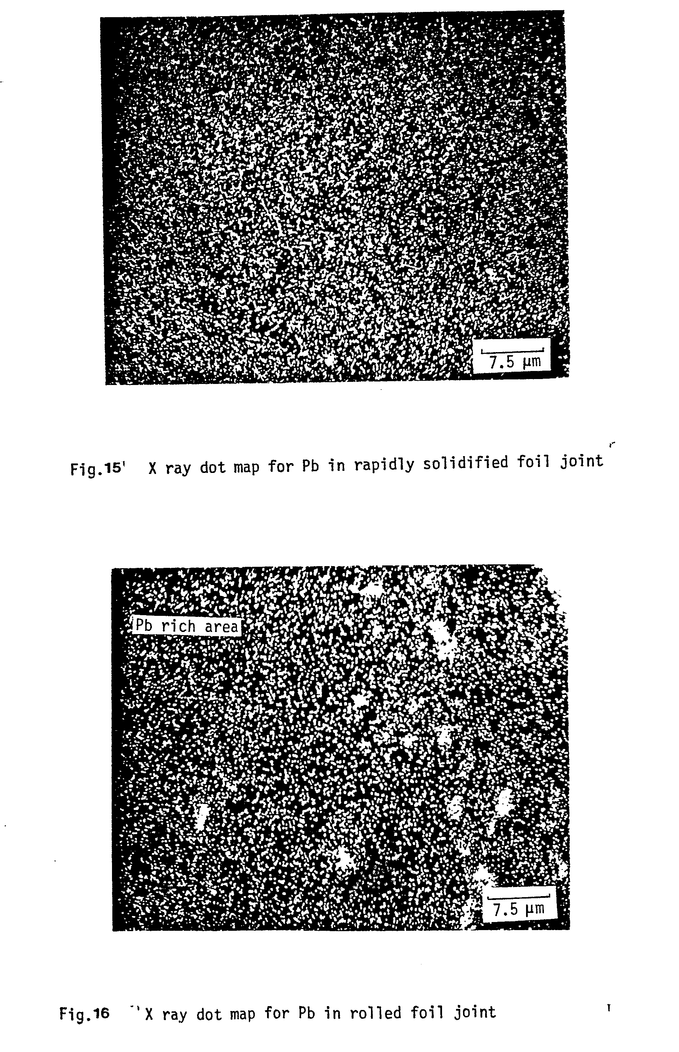

A solder foil preform of composition of Sample No. 3 as in Table 1 of dimensions of about 0.635 cm long x 0.635 cm wide x .005 cm thick (0.250" long x 0.250" wide x .002" thick) was placed on an as-received standard TO-3 electroless nickel plated lead frame. A silicon chip was then placed on the solder preform. The assembly was placed under a 40 mg compressive load and positioned in a controlled atmosphere belljar furnace. Soldering was performed in an atmosphere of pure dry argon. A thermocouple was attached to the heating plate to monitor temperature. In addition, a stereozoom microscope was installed outside the furnace for visual observation of the assembly during soldering. Heating time to the soldering temperature (about 365°C) was about 8 minutes. At approximately 365°C, the solder foil melted and flowed as observed by the microscope. At this point, the furnace was turned off and the joint was allowed to cool to room temperature. The joint was then immersed in a saturated sodium hydroxide solution kept at a temperature of 100-110°C for preferential dissolution of the silicon chip. After dissolution of the chip, the exposed solder surface, previously underneath the silicon chip was examined by scanning electron microscopy (SEM) for elemental distribution. X-ray dot map for Pb in such a surface is shown in Fig. 15 . The figure illustrates uniform distribution of Pb demonstrating homogeneity of a soldered joint made with a homogeneous rapidly solidified solder foil.

For comparison, an identical joint was made using commercially available rolled foil of the same composition of Sample No. 3 in Table 1. The soldering temperature of the rolled foil was about 375°C. X-ray dot map for Pb in the rolled foil joint is shown in Fig. 16, illustrating segregation of Pb.

Having thus described the invention in rather full detail, it will be understood that this detail need not be strictly adhered to but that various changes and modifications may suggest themselves to one skilled in the art, all falling within the scope of the invention as defined by the subjoined claims.

WE CLAIM:

1. A soldered article, said article having been soldered with a rapidly solidified, homogeneous, soldering filler metal foil.

2. A soldered article as recited in claim 1, said foil having a thickness ranging from 12 to 75 micrometers.

3. A soldered article as recited in claim 1, said foil having a composition consisting essentially of at least two elements selected from the group consisting of Au, Ag, Pb, Bi, Si, Sn, Sb, In and Ge.

4. A soldered article as recited in claim 1, said foil having a width of at least 2 millimeters and substantially uniform cross section along the length thereof.

5. A soldered article as recited in claim 1, said foild having a composition consisting essentially of the elements Sn and Pb.

6. A process for joining together two or more parts comprising the steps of:

(a) melting an alloy having a composition consisting essentially of at least two elements selected from the group consisting of Au, Ag, Pb, Bi, Si, Sn, Sb, In and Ge; and

(b) quenching the alloy on a rapidly moving chill surface at a rate of at least about $10^3 \,°C$/sec to form a homogeneous, soldering foil;

(c) interposing said foil as filler metal between the parts to be joined to form an assembly, the filler metal having a melting temperature less than that of any of the parts to be joined;

(d) heating the assembly to at least the temperature necessary to totally melt the filler metal; and

(e) cooling the assembly.

7. A process as recited in claim 6 wherein said alloy has a composition consisting essentially of the elements Sn and Pb.

8. A process for joining together two or more parts comprising the steps of:

(a) melting an alloy having a composition consisting essentially of at least two elements selected from the group consisting of Au, Ag, Pb, Bi, Si, Sn, Sb, In and Ge;

(b) quenching the alloy on a rapidly moving chill surface at a rate of at least $10^3{}^\circ$C/sec. to form a homogeneous, soldering foil;

(c) placing said foil as filler metal on one of the parts to be joined to form an assembly, the filler metal having a melting temperature less than that of any of the parts to be joined;

(d) heating the assembly to at least the temperature necessary to totally melt the filler metal;

(e) placing a second of the parts to be joined on the molten filler metal; and

(f) cooling the assembly.

9. A process as recited in claim 8 wherein said alloy has a composition consisting essentially of the elements Sn, Ag and Sb.

10. A process as recited in claim 8 wherein said alloy has a composition consisting essentially of the elements Sn and Pb.

FIGURE 1

FIGURE 2

10 µm    SN MAP        MA8128

FIGURE 3

10 µm    Ph MAP        MA-8129        1KX

FIGURE 4

**FIGURE 5**

**FIGURE 6**

FIGURE 7

Fig. 8    X-ray dot map for Sn  in rapidly solidified  63Sn-37Pb (w/o)
foil.

Fig. 9    X-ray dot map for Sn  in rapidly solidified  60Sn-40Pb (w/o) foil.

Fig. 10    X-ray dot map for Sn  in rapidly solidified  60Pb-40Sn (w/o) foil.

0144998

Fig. 11    X-ray dot map for  Sn  in rapidly solidified   85Pb-15Sn  (w/o)
foil.

Fig. 12    X-ray dot map for In  in rapidly solidified  97In-3Ag (w/o) foil.

Fig. 13    X-ray dot map for Ag   in rapidly solidified  97.5Pb-1.5Ag-1Sn (w/o) foil.

Fig. 14  X-ray dot map for Sn  in rapidly solidified  92.5Pb-5Sn-2.5Ag (w/o) foil.

Fig.15'   X ray dot map for Pb in rapidly solidified foil joint

Fig.16   X ray dot map for Pb in rolled foil joint